Europäisches Patentamt

European Patent Office

Office européen des brevets

(19)

(11) Numéro de publication : **0 092 681**
**B1**

(12) **FASCICULE DE BREVET EUROPÉEN**

(45) Date de publication du fascicule du brevet :
03.12.86

(21) Numéro de dépôt : 83102929.3

(22) Date de dépôt : 24.03.83

(51) Int. Cl.⁴ : **H 03 L   1/04**

(54) **Support d'oscillateur.**

(30) Priorité : 30.03.82 FR 8205422

(43) Date de publication de la demande :
02.11.83 Bulletin 83/44

(45) Mention de la délivrance du brevet :
03.12.86 Bulletin 86/49

(84) Etats contractants désignés :
**CH DE FR GB IT LI NL**

(56) Documents cités :
**BE-A-   453 600**
**FR-A-   858 055**
**US-A- 2 644 904**
**PROCEEDINGS OF THE TWENTY-SEVENTH ANNUAL FREQUENCYCONTROL SYMPOSIUM, New Jersey, 12-14 juin 1973, pages 199-217, Washington, USA. H. M. GREENHOUSE et al.: "A fast warmup quartz crystal oscillator"**

(73) Titulaire : **COMPAGNIE D'ELECTRONIQUE ET DE PIE-ZO-ELECTRICITE - C.E.P.E.**
**44, rue de la Glacière**
**F-95100 Argenteuil (FR)**

(72) Inventeur : **Stahl, André**
**5, rue Georges Clémenceau**
**F-91400 Orsay (FR)**
Inventeur : **Munier, Daniel**
**8, allée du Commandant Charcot**
**F-77200 Torcy (FR)**
Inventeur : **Bertrand, André**
**3, rue Jean Jaurès**
**F-92370 Chaville (FR)**

(74) Mandataire : **Ruellan-Lemonnier, Brigitte et al**
**THOMSON-CSF SCPI 19, avenue de Messine**
**F-75008 Paris (FR)**

EP 0 092 681 B1

Jouve, 18, rue St-Denis, 75001 Paris, France

## Description

La présente invention concerne un support d'oscillateur constitué par une embase de connexion recouverte d'un capot étanche, l'ensemble étant mis sous vide, à l'intérieur duquel un oscillateur est fixé par l'intermédiaire de fils. Ce support assure une isolation mécanique et thermique d'un oscillateur.

On peut, comme par exemple dans les procédés de localisation de balises par satellites, utiliser un oscillateur servant d'émetteur, placé à l'intérieur de chaque balise.

Un oscillateur doit délivrer un signal stable en fréquence, il faut donc qu'il travaille à une température constante qui est en principe sa température idéale de fonctionnement.

Il faut de plus qu'il supporte des agressions mécaniques qui peuvent être, des vibrations sinusoïdales de l'ordre de 5 g, des chocs d'environ 100 g pendant quelques millisecondes lors d'un larguage d'une balise en mer, par exemple.

Pour satisfaire à toutes ces conditions de fonctionnement, l'oscillateur sera placé sur un support mécanique recouvert d'un capot étanche.

Ce support mécanique remplit parfaitement son rôle d'isolant mécanique mais l'isolation thermique des capots connus est pratiquement inexistante. Les pertes thermiques sont en partie dues à des phénomènes de conduction existant aux niveaux des connexions mécaniques et électriques, à des phénomènes de rayonnement que l'on peut diminuer en réalisant sur le support des états de surfaces polis et de préférence argentés, et principalement à des phénomènes de convexion que l'on peut éliminer en créant un vide secondaire, meilleur que $10^{-4}$ torr, à l'intérieur du capot.

On peut également parfaire le vide en éliminant les gaz résiduels à l'aide d'un adsorbeur de gaz se présentant sous la forme d'une pastille en matériau à fort coefficient d'adsorption des gaz. L'oscillateur doit aussi avoir, une bonne tenue en fréquence en fonction du temps, c'est-à-dire une bonne résistance au vieillissement, une faible consommation de courant nécessaire à son alimentation et un faible coût de fabrication.

On connaît par une publication Proc. 34th Ann. Freq. Control Symposium USAERADCOM, Ft Monmouth NJ 07703, May 1980, dans l'article de H. W. Jackson, intitulé : « tactical miniature crystal oscillator », aux pages 449 à 456, un support d'oscillateur utilisé dans un satellite destiné à être mis sur orbite. Ce support d'oscillateur est constitué d'un premier conteneur dans lequel l'oscillateur est suspendu mais pas fixé à sa base, ce premier conteneur étant tendu en direction d'une embase par des fils servant aussi de connexions électriques. Un deuxième conteneur, fixé sur ladite embase, enveloppe le premier. Un vide secondaire est créé entre les deux conteneurs pour éviter des pertes thermiques dues à des phénomènes de convexion.

Ce support d'oscillateur est très complexe et l'utilisation de deux conteneurs, alourdit l'ensemble support. Puis cet ensemble support ne dissocie pas ses différentes fonctions, à savoir une isolation mécanique et une isolation thermique car les fils tendus servant à maintenir le premier conteneur font aussi office de connexions électriques. Ce mélange de fonctions ne permet sûrement pas d'avoir des caractéristiques mécaniques et électriques optimales.

La présente invention remédie à ces inconvénients en proposant un support d'oscillateur, ne comprenant qu'un capot ou conteneur étanche et recouvrant une embase de connexion, l'ensemble étant sous vide et ayant une fonction mécanique et une fonction électrique assurées par des moyens distincts.

Le support d'oscillateur selon l'invention est caractérisé en ce que l'oscillateur est suspendu à une potence par un premier fil et tendu en direction de l'embase par un second fil reliant alternativement la base de l'oscillateur et l'embase en plusieurs points d'ancrage.

De préférence, la base de l'oscillateur possède des bornes de sortie électriques reliées à des bornes de connexion de l'embase par des fils boudinés à faible conductibilité thermique.

Il est décrit ci-après à titre d'exemple et en référence aux figures du dessin annexé, un support d'oscillateur selon l'invention.

La figure 1 représente en élévation, le dispositif mécanique supportant l'oscillateur.

La figure 2 est une vue de dessus de la figure 1.

La figure 3 est une vue complète du support, en coupe partielle, montrant le capot et son queusot.

La figure 4 est une vue de côté du support avec une partie du capot arraché.

La figure 5 est une vue de dessus en coupe suivant l'axe V-V de la figure 3.

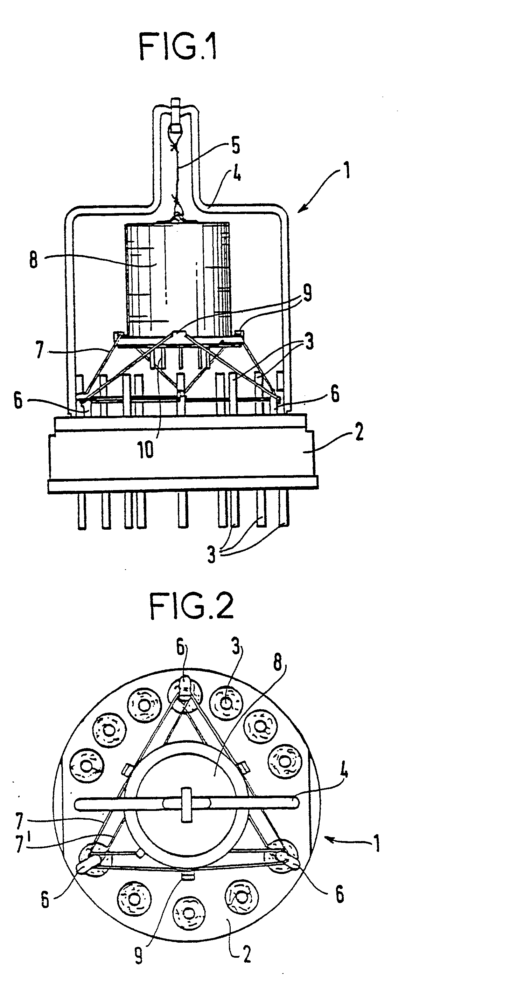

Dans la figure 1, l'embase 2 du support 1 comprend des bornes de connexion 3 la traversant, une potence 4 sur laquelle est fixé un fil métallique 5 de suspension et des crochets 6 sur lesquels s'accroche un fil métallique 7. L'oscillateur 8 est donc maintenu en place par le fil 5 et par le fil 7 qui passe alternativement sur des crochets 9 de la base de l'oscillateur et sur les crochets 6 de l'embase 2.

La figure 2 montre plus particulièrement la répartition géométrique des bornes de connexion 3 sur l'embase 2 et le trajet décrit par le fil métallique 7 qui relie directement par une boucle horizontale 7' les trois crochets 6 de l'embase 2 après avoir reliés alternativement les crochets 9 et les crochets 6.

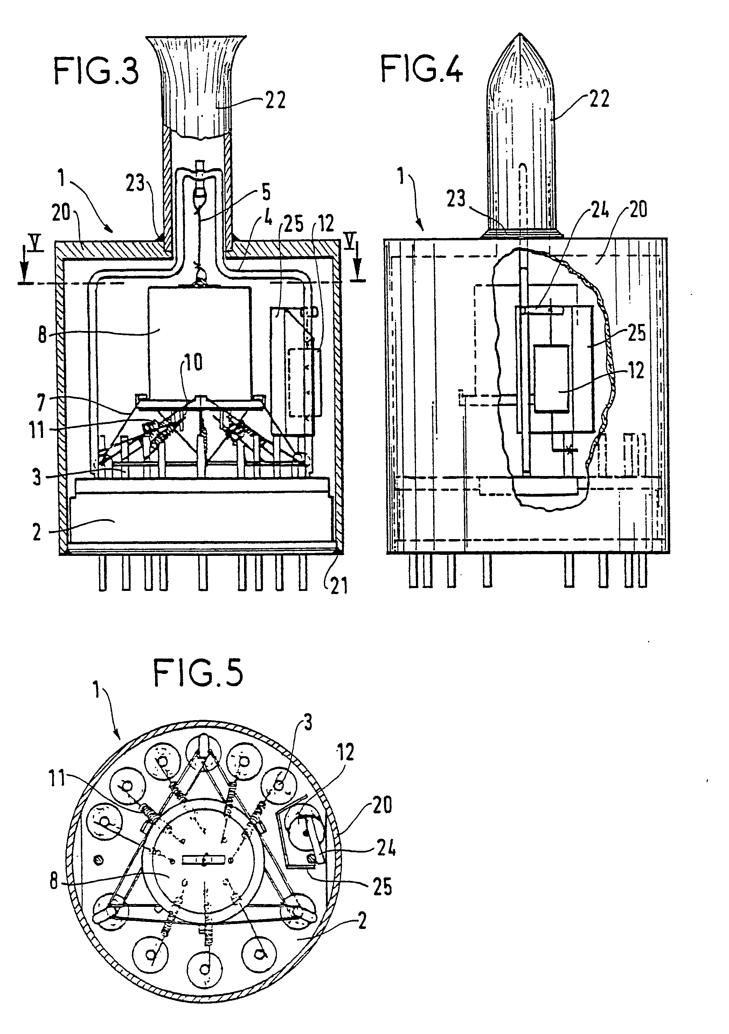

Dans la figure 3, en plus du dispositif mécanique du support, on peut voir les connexions électriques 11 qui se présentent sous la forme de fils boudinés, soudés électriquement, d'une part aux bornes de sortie électriques 10 de l'oscillateur 8 et d'autre part aux bornes 3 de connexion de l'embase 2. Un adsorbeur de gaz 12, se présentant sous la forme d'une pastille en matériau à fort coefficient d'adsorption des gaz, est fixé d'une part à la potence 4 par une barrette 24 et d'autre part à une borne de connexion 3 de l'embase 2. Avant la fermeture complète du support, cette pastille est activée à une température d'environ 500 °C ; la protection de l'oscillateur est assurée par un écran 25 fixé à la potence 4. Un capot 20 est fixé sur l'embase par une soudure 21 qui peut être une soudure à l'arc sous argon (soudure TIG). Un queusot 22 est fixé sur le capot par une brasure 23. Ce queusot peut être en cuivre fondu sous vide, il sert à brancher une pompe à vide sur le capot. L'embout de ce queusot est au départ cylindrique, et dès que l'on a atteint le vide désiré puis activé l'adsorbeur de gaz, on ferme le capot par queusotage, c'est-à-dire en pinçant l'extrémité du queusot, celui-ci prenant alors une forme particulière visible sur les figures 3 et 4.

La figure 5 montre la position de l'écran 25 assurant la protection de l'oscillateur 8.

Sans sortir du cadre de l'invention, ce support d'oscillateur peut être utilisé dans d'autres applications, par exemple pour des oscillateurs à haute stabilité réalisés en technologie hybride.

**Revendications**

1. Support d'oscillateur constitué par une embase (2) de connexion recouverte d'un capot étanche (20), l'ensemble étant mis sous vide, à l'intérieur duquel un oscillateur (8) est fixé par l'intermédiaire de fils (5, 7), caractérisé en ce que l'oscillateur (8) est suspendu à une potence (4) par un premier fil (5) et tendu en direction de l'embase (2) par un second fil (7) reliant alternativement la base de l'oscillateur et l'embase en plusieurs points d'ancrage (6, 9).

2. Support d'oscillateur selon la revendication 1, caractérisé en ce que la base de l'oscillateur (8) possède des bornes de sortie (10) électriques reliées à des bornes de connexion (3) de l'embase (2) par des fils boudinés (11) à faible conductibilité thermique.

3. Support d'oscillateur selon la revendication 1, caractérisé en ce qu'il comporte un adsorbeur de gaz (12) pour éliminer les gaz résiduels.

4. Support d'oscillateur selon la revendication 1, caractérisé en ce qu'il comporte un queusot (22), soudé sur le capot (20), permettant le branchement d'une pompe à vide et la fermeture du capot une fois le vide obtenu.

**Claims**

1. Oscillator carrier constituted by a connection base (2) covered by a tight hood (20), the unit being evacuated, and inside of which an oscillator (8) is fixed by means of wires (5, 7), characterized in that the oscillator (8) is suspended from a column (4) by a first wire (5) and tensioned in the direction of the base (2) by a second wire (7) alternatingly connecting the bottom of the oscillator with the base at a plurality of anchoring points (6, 9).

2. Oscillator carrier according to claim 1, characterized in that the bottom of the oscillator (8) is provided with electrical output terminals (10) connected to connection terminals (3) of the base (2) through coiled wires (11) of low thermal conductivity.

3. Oscillator carrier according to claim 1, characterized in that it comprises a gas adsorber (12) for eliminating residual gas.

4. Oscillator carrier according to claim 1, characterized in that it comprises a suction pipe (22) soldered on the hood (20) and permitting the connection of an evacuation pump and the closing of the hood after evacuation is obtained.

**Patentansprüche**

1. Träger für einen Oszillator, gebildet aus einem Anschlußsockel (2), der durch eine dichte Haube (20) abgedeckt ist, wobei die Baugruppe evakuiert ist und im Inneren derselben ein Oszillator (8) über Drähte (5, 7) befestigt ist, dadurch gekennzeichnet, daß der Oszillator (8) an einer Säule (4) durch einen ersten Draht (5) aufgehängt und in Richtung des Sockels (2) durch einen zweiten Draht (7) gespannt ist, welcher das Fußteil des Oszillators und den Sockel an mehreren Verankerungspunkten (6, 9) abwechselnd miteinander verbindet.

2. Oszillatorträger nach Anspruch 1, dadurch gekennzeichnet, daß das Fußteil des Oszillators (8) elektrische Ausgangsanschlüsse (10) besitzt, die mit Verbindungsanschlüssen (3) des Sockels (2) über Drähte (11) verbunden sind, die schraubenförmig aufgewickelt sind und eine geringe Leitfähigkeit aufweisen.

3. Oszillatorträger nach Anspruch 1, dadurch gekennzeichnet, daß er einen Gasadsorber (12) umfaßt, um Restgase zu beseitigen.

4. Oszillatorträger nach Anspruch 1, dadurch gekennzeichnet, daß er ein an die Haube (20) angelötetes Pumpröhrchen (22) umfaßt, welches das Anschließen einer Evakuierpumpe und das Verschließen der Haube nach Herstellung des Vakuums gestattet.

# FIG.1

# FIG.2

FIG.3

FIG.4

FIG.5